# EUROPÄISCHE PATENTSCHRIFT

(11) **EP 3 233 873 B1**
(45) Veröffentlichungstag und Bekanntmachung des Hinweises auf die Patenterteilung: **26.06.2019**
(21) Anmeldenummer: 15813294.4
(22) Anmeldetag: 08.12.2015
(51) Int. Cl.: C07F 9/6584, H01L 51/00, H01L 51/05, H01L 51/42, H01L 51/50

(54) **PROAZAPHOSPHATRANE ALS N-DOTIERSTOFFE IN DER ORGANISCHEN ELEKTRONIK**
PROAZAPHOSPHATRANES AS N-DOPANTS IN ORGANIC ELECTRONICS
PROAZAPHOSPHATRANES EN TANT QU'AGENTS DE DOPAGE DE TYPE N EN ÉLECTRONIQUE ORGANIQUE

(30) Priorität: 19.01.2015 DE 102015200690
(43) Veröffentlichungstag der Anmeldung: 25.10.2017
(73) Patentinhaber: Siemens Aktiengesellschaft, 80333 München (DE)
(72) Erfinder: KESSLER, Florian, 91315 Höchstadt an der Aisch (DE); PECQUEUR, Sébastien, 62136 La Couture (FR); SCHMID, Günter, 91334 Hemhofen (DE)
(86) Internationale Anmeldenummer: PCT/EP2015/078921
(87) Internationale Veröffentlichungsnummer: WO 2016/116205

(56) Entgegenhaltungen:
- JP-A- 2013 181 072

## Beschreibung

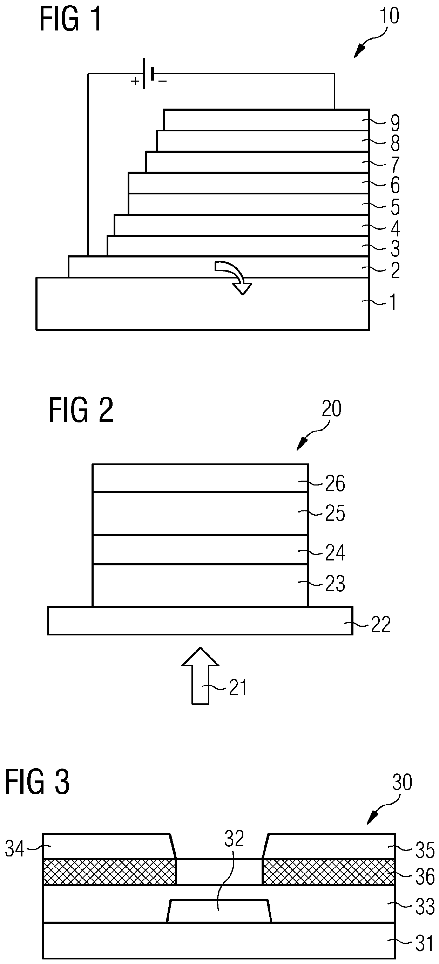

Die vorliegende Erfindung betrifft einen n-Dotierstoff zur Dotierung organischer Elektronentransportmaterialien, wobei der n-Dotierstoff mindestens eine Proazaphosphatran-Verbindung mit einem dreifach N-substituierten Phosphoratom nach Formel 1 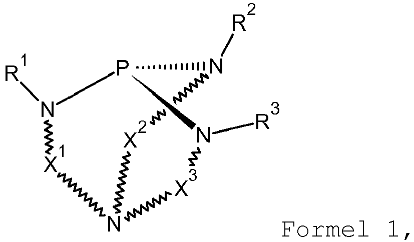 umfasst, wobei
R¹ - R³ unabhängig voneinander ausgesucht sind aus der Gruppe R umfassend H, D, C1-C60 gesättigtes oder ungesättigtes Alkyl, Cycloalkyl, Heteroalkyl, Heterocycloalkyl, C1-C60 Aryl, Alkylaryl, Heteroaryl, Ether, Ester und PR'₃, wobei die Gruppe R' die Substituenten der Gruppe R ohne PR'₃ umfasst, wobei R¹ - R³ unabhängig voneinander verbrückt sein können;
X¹ - X³ unabhängig voneinander ausgesucht sind aus der Gruppe umfassend eine Bindung und substituierte oder nicht-substituierte C1-C10 Alkylen, Cycloalkylen, Arylen und Alkylarylen. Stand der Technik Üblicherweise gilt für Bauelemente der organischen Elektronik, dass ihre Effizienz umso höher liegt, je geringer der Spannungsabfall über die in diesen Bauteilen enthaltenen Transportschichten mit p-(Loch)- bzw. n-(Elektronen)-Leitfähigkeit ist. Dieser funktionale Zusammenhang gilt insbesondere bei organischen Leuchtdioden (schematischer Schichtaufbau dargestellt in Figur 1) und organischen Solarzellen (Figur 2). Für organische Feldeffekt-Transistoren (Figur 3) gelten ähnliche Zusammenhänge, wobei in diesen Fällen insbesondere die Effizienz der Injektion von Ladungsträgern von der Größe der Kontaktwiderstände abhängt. Ist man in der Lage diese zu minimieren, so erhöht man die effektive Mobilität des Halbleiters. Neben dem Einsatz geeigneter elektrisch leitender organischer Materialien hat sich dabei in der Technik durchgesetzt, dass zusätzliche Stoffe in die Schichten eingebracht werden, welche bewirken, dass die intrinsische Leitfähigkeit dieser Materialien erhöht wird. Je nach gewünschtem Zweck unterscheidet man dabei p- oder n-Dotanden, welche jeweils die p- oder die n-Leitfähigkeit von Transport-/Kontaktschichten verbessern. Die Zahl der verfügbaren n-Dotierstoffe für diese organisch elektronischen Bauelemente ist sehr begrenzt, was die Ausgestaltungsmöglichkeiten und derzeitige technische Leistungsfähigkeit organischer Bauelemente limitiert. Deshalb ist neben der Anwendung geeigneter Dotierstoffe in OLEDs, die Nutzung dieser in Feldeffekttransistoren als Kontaktdotierung, insbesondere bei komplementären Schaltkreisen bzw. in Bipolar-Bauelementen von großer Bedeutung.

In der Literatur finden sich einige Stellen, welche sich mit der Synthese und den Eigenschaften von Phosphazenen allgemein beschäftigen. So beispielsweise das Buch "Superbases for Organic Synthesis - Guanidines, Amidines, Phosphazenes and Related Organocatalysts" von Tsutomo Ishikawa (WILEY, 2009, ISBN: 978-0-470-51800-7). Des Weiteren wird dieser Themenkomplex beispielsweise auch in Núñez et al. J. Org. Chem. 1996, 61, 8386 behandelt, welcher u.a. die Synthese von Hexaimidazolylcyclotriposphazen beschreibt. In diesen Literaturstellen werden weder für die Phosphazene noch insbesondere für die Proazaphosphatrane Einsatzgebiete im Bereich der organischen Elektronik genannt.

In der Patentliteratur wird der Einsatz speziell substituierter Phosphazene in der organischen Elektronik als Elektronenleiter angeführt. So offenbart zum Beispiel die WO 2009/153276 A1 eine organische Leuchtdiode, enthaltend mindestens eine cyclische Phosphazenverbindung nach folgender Formel 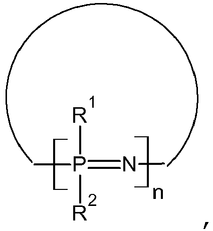 eine Licht-emittierende Schicht aufgebaut aus mindestens einem Matrixmaterial und mindestens einem Emittermaterial, wobei das mindestens eine Matrixmaterial mindestens eine cyclische Phosphazenverbindung enthält, die Verwendung von cyclischen Phosphazenverbindungen in organischen Leuchtdioden sowie eine Vorrichtung ausgewählt aus der Gruppe bestehend aus stationären Bildschirmen, mobilen Bildschirmen und Beleuchtungseinheiten enthaltend mindestens eine erfindungsgemäße organische Leuchtdiode und ausgewählte cyclische Phosphazenverbindungen und Verfahren zu deren Herstellung.

In der WO 2012 175219 A1 wird eine elektronische Vorrichtung offenbart, welche eine Verbindung A-B umfasst, mit
B = 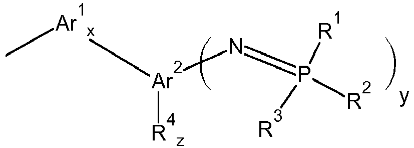 und
A = 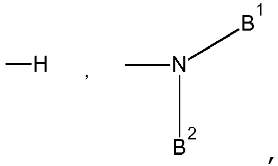 oder B³
worin - Ar¹ ein C6-C18-Arylen, welches ein- oder mehrkernig und gegebenenfalls durch eine oder mehrere C1-C10-Alkyl oder C3-C10-Cycloalkylgruppen substituiert sein kann, - Ar² ein C6-C18-Aren Skelett, welches gegebenenfalls mit elektronenabgebenden Gruppen R⁴ substituiert ist, - B¹ und B² unabhängig ausgewählt sind aus B und Ar², -B³ unabhängig ausgewählt ist aus der gleichen Gruppe wie B, - R¹, R², R³ unabhängig ausgewählt sind aus Alkyl, Arylalkyl, Cycloalkyl, Aryl, Dialkylamino, -X ausgewählt ist aus 0, 1, 2 und 3, wobei für x> 1 jedes Ar1 verschieden sein kann, - y eine nicht Null verschiedene ganze Zahl bis zu der Gesamtzahl von Valenzstellen auf dem Aren-Skelett, - z eine ganze Zahl von Null bis zur Gesamtzahl von Valenzstellen auf dem Aren-Skelett minus y sowie einer entsprechenden Verbindung gemäß Formel AB.

Die JP 2013 181072 A beispielsweise beschreibt die Verwendung von 2,8,9-triisobutyl-2,5,8,9-tetraaza-1-phosphabicyclo [3.3.3]undecane (TiBTa PU) als Katalysator zur Synthese von Ladungstransportmaterialien für die organische Elektronik.

Die Verwendung speziell substituierter Proazaphosphatrane als n-Dotanden zur Erhöhung der Leitfähigkeit organischer Elektronenleiter und nicht als Elektronenleiter selbst, ist hingegen durch den Stand der Technik nicht nahe gelegt.

Es ist daher die Aufgabe der vorliegenden Erfindung eine Substanzklasse bereitzustellen, welche in der Lage ist, durch Dotierung organischer Elektronenleiter deren Leitfähigkeit signifikant zu erhöhen. Zudem ist es die Aufgabe dieser Erfindung ein Verfahren bereitzustellen, durch welches n-Transportschichten erhältlich sind, welche eine verbesserte Leitfähigkeit aufweisen, sowie die Bereitstellung organisch elektrischer Bauelemente aufweisend diese Transportschichten.

Gelöst wird diese Aufgabe durch die Merkmale des Anspruchs 1. Besondere Ausführungsformen der Erfindung werden in den Unteransprüchen wiedergegeben.

Erfindungsgemäß ist die Verwendung als n-Dotierstoff zur Dotierung organischer Elektronentransportmaterialien dadurch gekennzeichnet, dass der n-Dotierstoff mindestens eine Proazaphosphatran-Verbindung mit einem dreifach N-substituiertem Phosphoratom nach Formel 1 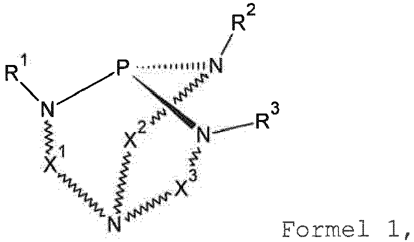 umfasst, wobei
R¹ - R³ unabhängig voneinander ausgesucht sind aus der Gruppe R umfassend H, D, C1-C60 gesättigtes oder ungesättigtes Alkyl, Cycloalkyl, Heteroalkyl, Heterocycloalkyl, C1-C60 Aryl, Alkylaryl, Heteroaryl, Ether, Ester und PR'₃, wobei die Gruppe R' die Substituenten der Gruppe R ohne PR'₃ umfasst, wobei R¹ - R³ unabhängig voneinander verbrückt sein können;
X¹ - X³ unabhängig voneinander ausgesucht sind aus der Gruppe umfassend eine Bindung und substituierte oder nicht-substituierte C1-C10 Alkylen, Cycloalkylen, Arylen und Alkylarylen. Es hat sich überraschenderweise gezeigt, dass insbesondere n-Dotierstoffe, welche eine Proazaphosphatran-Gruppe nach der Formel 1 aufweisen in der Lage sind, die Elektronenleitfähigkeit organischer Elektronentransportmaterialien signifikant zu erhöhen. Dieser Effekt ist dabei nicht auf die intrinsische Leitfähigkeit des erfindungsgemäßen n-Dotanden zurückzuführen, sondern ergibt sich aufgrund der Wechselwirkung des erfindungsgemäßen n-Dotanden mit einem Elektronentransportmaterial. Diese signifikante Erhöhung der Leitfähigkeit lässt sich dabei sowohl mit Substanzen erhalten, welche als funktionelle Einheiten nur Proazaphosphatran-Gruppen aufweisen als auch mit Substanzen, in denen die Proazaphosphatran-Gruppe nur einen Bestandteil der funktionellen Gruppen des Moleküls darstellt. Ohne durch die Theorie gebunden zu sein kann dieses Verhalten dadurch begründet sein, dass die Proazaphosphatrane sehr starke Basen sind, welche zudem in der protonierten Form eine außergewöhnliche Stabilität aufweisen. Die Proazaphosphatrane können durch saure Wasserstoffe am Phosphor und nicht wie die üblichen Phosphazen-Basen am Stickstoff protoniert werden:

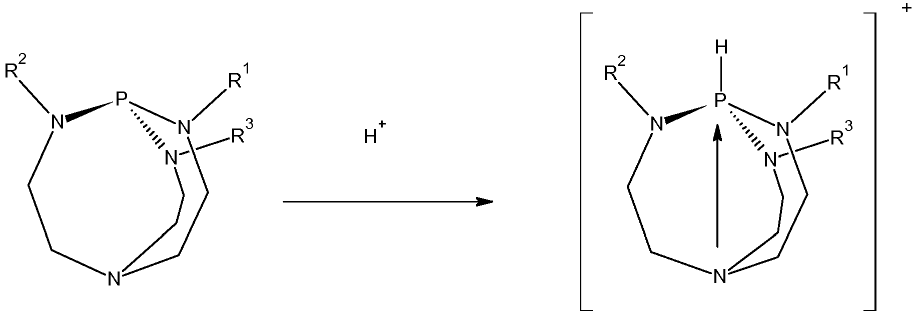

Diese protonierte Form (Azaphosphatran) kann durch Ladungskompensation durch den nicht an den Phosphor gebundenen Stickstoff stabilisiert werden (Transannulierung). Die positive Ladung am Azaphosphatran wird dabei durch den Brückenkopf-Stickstoff durch Transannulierung stabilisiert. Der N-P Abstand in Azaphosphatranen beträgt ca. 2 Å, während er in Proazaphosphatranen ca. 3Å beträgt. Dies zeigt deutlich die Bindungsbildung zwischen den Brückenkopf-N und P-Atomen durch Protonierung (bzw. Koordination eines Moleküls). Wie unten dargestellt, kann ein ähnlicher Mechanismus auch mit anderen aziden Verbindung (Z) wie beispielsweise anderen Matrixmaterialien erfolgen:

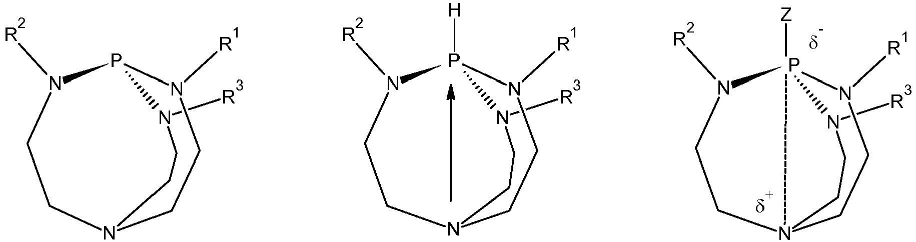

Das Proazaphosphatran kann also z.B. ein azides Proton von einem Elektronentransportmaterial (ETM) aufnehmen und dadurch die gewünschte negative Ladung auf dem ETM erzeugen. Alternativ kann das Proazaphosphatran wie weiter unten dargestellt insgesamt als Elektronenpaar-Donor wirken und ein Matrixmolekül an den Phosphor koordinieren und dabei eine negative (Teil)ladung auf dem ETM generieren. Es kann zur Bildung von Anionen und Kationen kommen.

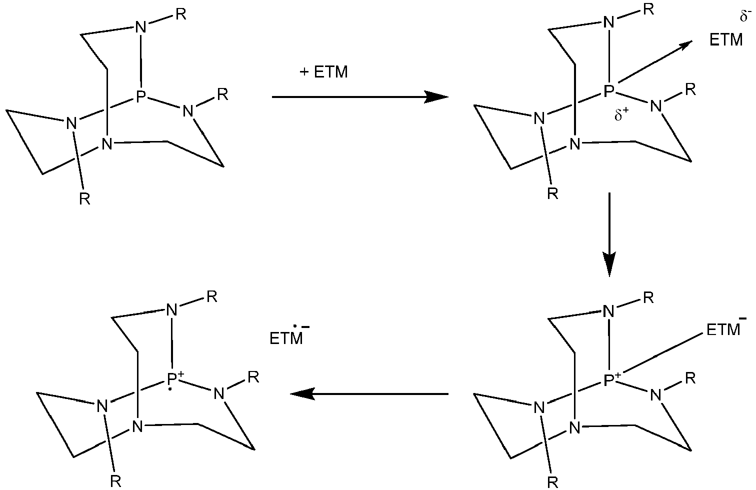

Die erfindungsgemäßen Substituenten der Gruppe R scheinen dabei insbesondere in der Lage, wahrscheinlich durch ihren +i-Effekt, die Basizität des zentralen Phosphor-Atoms noch weiter zu erhöhen. Zudem sind diese Substituenten klein genug, so dass ein ungehinderter Zutritt zu dem zentralen Phosphor Atom ermöglicht wird. Dies kann zu einer besonders schnellen Kinetik und einer guten Umsetzung beispielsweise mit Elektronentransportmaterialien führen. Auch die erfindungsgemäße Auswahl der Substituenten Z führt anscheinend dazu, dass eine besonders gute Stabilisierung des Azaphosphatrans stattfindet. Ohne durch die Theorie gebunden zu sein, ergibt sich das wahrscheinlich dadurch, dass durch relativ kurze Substituenten Z eine effektive Transannulation ermöglicht wird. Größere Substituenten Z können hingegen zu einem zu großen Abstand des nicht an das Phosphor-Atom gebundenen Stickstoffs führen, welches die Ladungskompensation verschlechtern kann. Diese Eigenschaften führen also dazu, dass die erfindungsgemäße Substanzklasse als n-Dotand wirkt. Durch die starke Basizität der Verbindung werden demzufolge Dotanden erhalten, welche eine verbesserte Dotierungswirkung im Vergleich zum im Stand der Technik genannten n-Dotanden aufweisen. Der erfindungsgemäße N-Dotand kann demzufolge natürlich auch als Blockiermaterial in p-leitfähigen Schichten eingesetzt werden.

Unter einer Proazaphosphatran-Gruppe im Sinne der Erfindung wird eine Verbindung verstanden, welche mindestens eine Proazaphosphatran-Gruppe nach der Formel 1 im Molekül aufweist. Dabei kann es sich um ein geladenes Molekül oder aber auch um eine Salzverbindung handeln, welche Ionen aufweist, wobei mindestens ein Ion eine Proazaphosphatran-Gruppe umfasst. Signifikant für die Proazaphosphatran-Gruppe ist die Anbindung von 3 Stickstoffen an das zentrale Phosphor-Atom und die Anbindung eines 4. Stickstoffs an die 3 phosphorgebundenen Stickstoffe. Des Weiteren ist es aber auch möglich, dass der erfindungsgemäße Dotierstoff neben der Proazaphosphatran-Einheit auch weitere funktionelle Gruppen aufweist.

Erfindungsgemäß werden die Substanzen mit mindestens einer Proazaphosphatran-Gruppe als n-Dotierstoff eingesetzt. Dies bedeutet insbesondere, dass es nicht erfindungsgemäß ist, dass diese Substanzen alleine innerhalb einer Schicht in einem organisch elektronischen Bauteil eingesetzt werden. Dies deshalb nicht, da die Grundleitfähigkeit dieser Verbindungsklasse für effektive organisch elektronische Bauteile unzureichend ist. Dieser Dotierstoff ist also zur Wechselwirkung mit einem Elektronentransportmaterial bestimmt. Hier hat sich insbesondere gezeigt, dass neben der starken Basizität auch anscheinend die HOMO-Level der erfindungsgemäßen n-Dotanden derart ausgebildet sind, dass diese effektiv mit den LUMO-Level der gängigen Elektronentransportmaterialien in Wechselwirkung treten können. Unter Dotierstoff in diesem Zusammenhang wird also ein Stoff verstanden, welcher zusammen mit dem Elektronentransportmaterial, nach dem Fachmann bekannten Herstellungsverfahren, zusammen abgeschieden wird. Dabei ist es insbesondere bevorzugt, dass der molare Anteil des n-Dotierstoffes in der Schicht nicht oberhalb des molaren Anteils des Elektronentransportmaterials liegt. Üblicherweise ist die Konzentration des erfindungsgemäßen n-Dotierstoffes in einer Schicht deutlich geringer als der des Elektronentransportmaterials. Der erfindungsgemäße n-Dotierstoff zeigt zudem als Einzelsubstanz in einer Schicht abgeschieden eine deutlich geringere elektrische Leitfähigkeit als Schichten aus Elektronentransportmaterialien. Durch das gemeinsame Abscheiden wird die maximale Leitfähigkeit der Elektronentransportmaterialien signifikant erhöht und zudem ergibt sich bei kleineren Spannungen schon ein deutlich höherer Stromfluss. Weiterhin ergibt sich die Funktion als n-Dotand daraus, dass in p-leitenden Schichten die erfindungsgemäßen n-Dotanden als Blockiermaterial wirken. Dies auch in Abgrenzung zu Elektronentransportmaterialien.

In einer besonders bevorzugten Ausführungsform der Erfindung können die X¹ - X³ unabhängig voneinander ausgesucht sein aus der Gruppe umfassend eine Bindung und substituierte oder nicht-substituierte C1-C6 Alkylen, Cycloalkylen, Arylen und Alkylarylen. Wie schon weiter oben erwähnt, scheinen insbesondere die kurzkettigen Kohlenwasserstoffe in der Lage zu sein, einen besonders guten n-Dotiereffekt zu erreichen. Dies kann daher rühren, dass neben der schon oben erwähnten verbesserten Transannulation durch die sterischen Eigenschaften kleiner Substituenten Z, zudem auch durch diese Auswahl an Substituenten ein +i-Effekt ausgeübt wird, welcher die Basizität des Phosphor-Atoms erhöhen kann. Beide Effekte können zu einer besseren Dotierwirkung der Verbindung beitragen.

In einem bevorzugten Aspekt der Erfindung können die X¹ - X³ unabhängig voneinander ausgesucht sein aus der Gruppe umfassend eine Bindung und substituierte oder nicht-substituierte C1-C5 Alkylen. Gerade die kurzkettigen Alkylsubstituenten für die X¹ - X³ scheinen die Ladungskompensation nach Aufnahme eines Protons und damit die Stabilisierung der Base zu verbessern. Dies kann zu einer schnellen Reaktionskinetik und einer Gleichgewichtseinstellung deutlich auf Seiten der protonierten Base beitragen.

In einer bevorzugten Ausführungsform der Erfindung kann mindestens eines der X¹ - X³ eine substituierte oder nicht-substituierte C2 Alkylengruppe sein. Es hat sich insbesondere gezeigt, dass eine Verbindung mit sehr kurzkettiger Alkylen-Gruppe zu einer besonders vorteilhaften Positionierung des nicht an den Phosphor gebundenen Stickstoffs beitragen kann. Dies kann zu einer vorteilhaften Transannulierung und damit einem besonders guten Dotiereffekt beitragen.

In einer weiteren erfindungsgemäßen Ausgestaltung kann jedes der X¹ - X³ eine substituierte oder nicht-substituierte C2 Alkylengruppe sein. Eine Anbindung des nicht an den Phosphor gebundenen Stickstoffs über C2-Alkylengruppen an die restlichen Stickstoffe führt anscheinend zu einer besonders geeigneten, symmetrischen Positionierung des nicht-phosphorgebundenen Stickstoffes, welches nach Aufnahme eines Protons, zu einer besonders guten Stabilisierung der Verbindung beitragen kann. Somit können durch diese Ausführungsform, besonders vollständige Umsetzung mit Elektronentransportmaterialien erreicht werden, welches zu einer besonders guten Dotierwirkung führen kann.

In einem weiteren erfindungsgemäßen Aspekt können mindestens zwei der R¹ - R³ über eine Brücke miteinander verbunden sein. Des Weiteren kann es vorteilhaft sein, dass mindestens 2 der an das Phosphor-Atom gebundenen Stickstoffe über eine weitere Brücke miteinander verbunden sind. Diese Brücke kann, wahrscheinlich bedingt durch die reduzierte Beweglichkeit der an das Phosphor-Atom gebundenen Stickstoffe, dazu führen, dass das zentrale Phosphor-Atom nach Aufnahme eines Protons besonders effektiv vom Zutritt weiterer Verbindungen geschützt ist. Dies kann zu einer besonders effektiven Protonenübertragung wie auch einer besonders stabilen Base beitragen.

In einer bevorzugten Ausführungsform der Erfindung kann der n-Dotierstoff nur eine Proazaphosphatran-Gruppe (PN₄) aufweisen. Aufgrund der starken Basizität der Proazaphosphatran-Gruppe hatte sich als geeignet erwiesen, wenn die erfindungsgemäßen N-Dotierstoffe nur eine Proazaphosphatran-Gruppe aufweisen. Diese Verbindungen ergeben mit dem erfindungsgemäßen Substitutionsmuster n-Dotanden, welche sich mit den gängigen Herstellmethoden organischer Schichten sowohl in Nassprozessen wie auch mittels Vakuumverfahren gut verarbeiten lassen.

In einer besonderen Ausgestaltung der Erfindung kann der n-Dotierstoff mindestens eine Verbindung der folgenden Formeln 2 - 14 umfassen

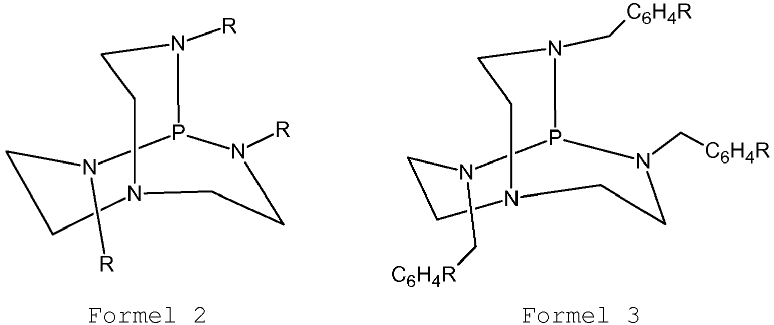

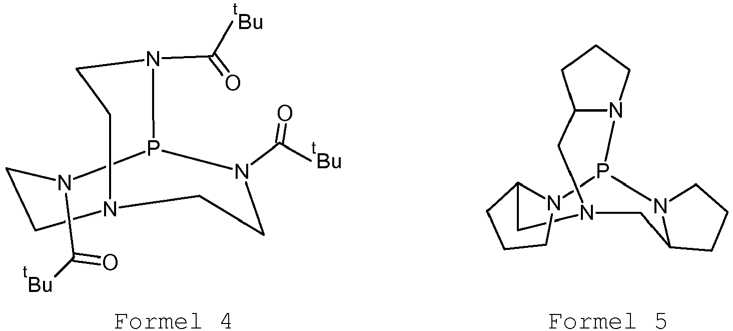

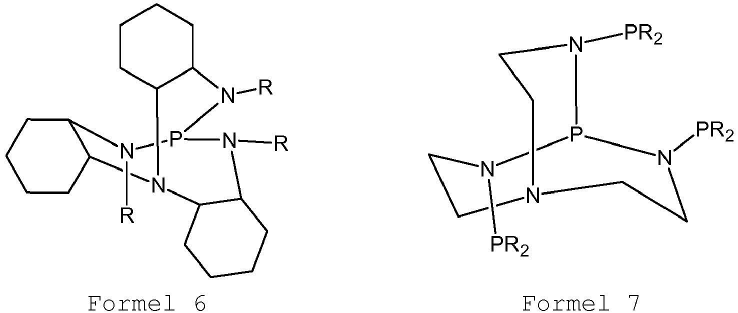

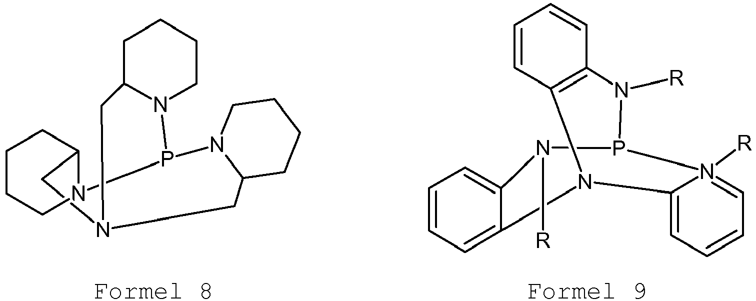

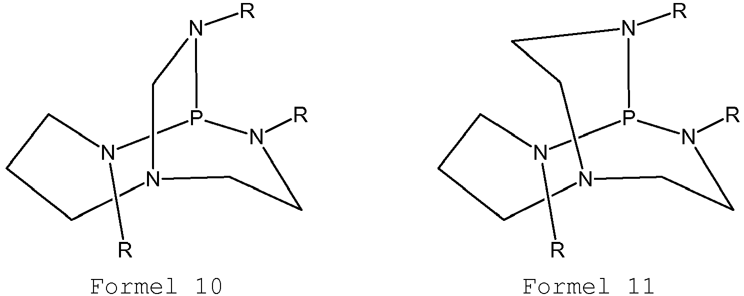

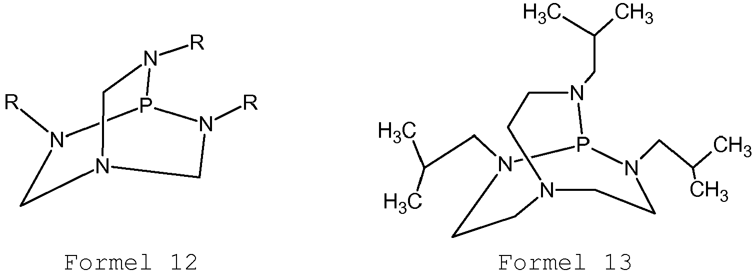

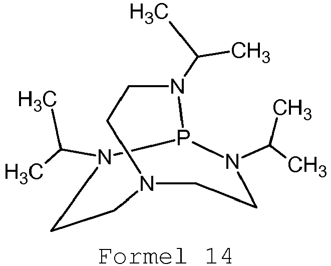

Insbesondere diese Verbindungen haben sich aufgrund ihrer Basizität, ihrer elektronischen Eigenschaften und aufgrund ihres Molekulargewichts zur Dotierung von Elektronentransportmaterialien als geeignet erwiesen. Diese Verbindung zeichnen sich durch eine gute Löslichkeit aus, welches auch eine Prozessführung durch eine Nassphase ermöglicht. Damit lassen sich diese Verbindungen flexibel einsetzen und mit diesen können homogene dotierte Schichten erhalten werden.

Weiterhin erfindungsgemäß ist ein Verfahren zur Herstellung n-leitender organisch elektrischer Schichten, wobei der erfindungsgemäße organische n-Dotierstoff zusammen mit einem Matrixmaterial innerhalb einer Schicht abgeschieden und der n-Dotierstoff und das Matrixmaterial zur Reaktion gebracht werden. Ohne durch die Theorie gebunden zu sein, kann dabei das zur Reaktion bringen nach dem weiter oben angegebenen Reaktionsmechanismus stattfinden, wobei das Elektronentransportmaterial ein Proton an den erfindungsgemäßen n-Dotanden abgibt. Es muss an dieser Stelle aber nicht zwangsläufig ein Proton übertragen werden. Es kann auch alternativ erst zu einer elektrostatischen Wechselwirkung des erfindungsgemäßen n-Dotanden mit dem Elektronentransportmaterial kommen, welches anschließend zu einer Übertragung von Elektronen auf das Elektronentransportmaterial führt. Dabei kann das zur Reaktion bringen aufgrund einer geeigneten Reaktionskinetik automatisch durch das gleichzeitige Abscheiden in einer Schicht erfolgen. Je nach gewähltem Elektronentransportmaterial und eingesetztem n-Dotand kann das zur Reaktion bringen auch über eine anschließende thermische Anregung induziert werden. Für dieses Verfahren lassen sich die gängigen Elektronentransportmaterialien einsetzen, welche dem Fachmann im Rahmen der organischen Elektronik geläufig sind. Das Abscheiden beider Materialien kann dabei sowohl aus der Nassphase wie auch durch einen Vakuumprozess erfolgen. Das Proazaphosphatran dient dabei als n-Dotand und kann entweder durch Co-Verdampfen mit einem Elektronentransportmaterial oder durch Mischen eines Proazaphosphatrans mit einem ETM und anschließendem Flüssigprozessieren (z.B. Spin Coating, Inkjet Printing, Slot Coating etc.) seine Dotierwirkung entfalten. Aufgrund der guten Löslichkeit auch in sehr unpolaren Lösungsmitteln sind die Proazaphosphatran-Basen sehr gut für die Flüssigprozessierung geeignet. Die größeren Moleküle sind thermisch sehr stabil und können im Hochvakuum im besonders bevorzugten Temperaturbereich von 150 - 250 °C unzersetzt verdampft werden, wodurch sie für die Vakuumprozessierung geeignet sind.

In einer besonderen Ausführungsform des Verfahrens kann das Matrixmaterial ein elektronenleitendes Matrixmaterial ausgesucht aus der Gruppe umfassend 2,2',2" -(1,3,5-Benzinetriyl)-tris(1-phenyl-1-H-benzimidazole), 2-(4-Biphenylyl)-5-(4-tert-butylphenyl)-1,3,4-oxadiazole; 2,9-Dimethyl-4,7-diphenyl-1,10-phenanthroline (BCP), 8-Hydroxyquinolinolato-lithium; 4-(Naphthalen-1-yl)-3,5-diphenyl-4H-1,2,4-triazole; 1,3-Bis[2-(2,2'-bipyridine-6-yl)-1,3,4-oxadiazo-5-yl]benzene; 4,7-Diphenyl-1,10-phenanthroline (BPhen); 3-(4-Biphenylyl)-4-phenyl-5-tert-butylphenyl-1,2,4-triazole ;Bis(2-methyl-8-quinolinolate)-4-(phenylphenolato)aluminium; 6,6'-Bis[5-(biphenyl-4-yl)-1,3,4-oxadiazo-2-yl]-2,2'-bipyridyl ;2-phenyl-9,10-di(naphthalen-2-yl)-anthracene; 2,7-Bis[2-(2,2'-bipyridine-6-yl)-1,3,4-oxadiazo-5-yl]-9,9-dimethylfluorene; 1,3-Bis[2-(4-tert-butylphenyl)-1,3,4-oxadiazo-5-yl]benzene; 2-(naphthalen-2-yl)-4,7-diphenyl-1,10-phenanthroline; 2,9-Bis(naphthalen-2-yl)-4,7-diphenyl-1,10-phenanthroline; Tris(2,4,6-trimethyl-3-(pyridin-3-yl)phenyl)borane; 1-methyl-2-(4-(naphthalen-2-yl)phenyl)-1H-imidazo[4,5-f][1,10]phenanthroline; Phenyl-dipyrenylphosphine oxide; 3,3',5,5'-tetra[(m-pyridyl)-phen-3-yl]biphenyl; 1,3,5-tris[(3-pyridyl)-phen-3-yl]benzol; 4,4'-bis(4,6-diphenyl-1,3,5-triazin-2-yl)biphenyl; 1,3-bis[3,5-di(pyridin-3-yl)phenyl]benzol; Diphenylbis(4-(pyridin-3-yl)phenyl)silan; 3,5-di(pyren-1-yl)pyridin; 1,3,5-tri(p-pyrid-3-yl-phenyl)benzol; 2,4,6-tris(3'-(pyridin-3-yl)biphenyl-3-yl)-1,3,5-triazin; Naphthalintetracarbonsäuredianhydrid bzw. dessen Imide; Perylentetracarbonsäuredianhydrid bzw. dessen Imide; Materialien basierend auf Silolen mit einer Silacyclopentadieneinheit sein. Diese Elektronentransportmaterialien lassen sich aufgrund ihrer elektronischen Eigenschaften (HOMO/LUMO-Level) gut mit den erfindungsgemäßen Proazaphosphatran-Dotanden zur Reaktion bringen. Durch das zusätzliche Eindotieren der Proazaphosphatrane lässt sich insbesondere die Leitfähigkeit der Elektronentransportmaterialien deutlich erhöhen. Dabei kann es vorteilhaft sein, dass das molare Verhältnis zwischen erfindungsgemäßem n-Dotanden zum Elektronentransportmaterial von ≥ 0,001 bis zu ≤ 1, bevorzugt von ≥ 0,005 bis zu ≤ 0,5, besonders bevorzugt von ≥ 0,01 bis zu ≤ 0,25 beträgt. Es kann also vorteilhaft sein, dass ein deutlicher Überschuss an Elektronentransportmaterial bzw. eine Mischung von Elektronentransportmaterialien eingesetzt wird.

Weiterhin erfindungsgemäß ist eine n-leitende organisch elektrische Schicht, hergestellt nach dem erfindungsgemäßen Verfahren. Durch das oben vorgestellte Verfahren lassen sich insbesondere homogene Schichten erhalten, welche sich für den Einsatz in Bauelementen der organischen Elektronik eignen. Dabei sind, wie schon erwähnt, insbesondere die erfindungsgemäßen Proazaphosphatrane geeignet, um mit den Standardverfahren der organischen Elektronik verarbeitbar zu sein. Zudem zeichnen sich die derart hergestellten Schichten dadurch aus, dass sie eine geringe Kristallisationsneigung aufweisen, welches zu einer längeren Lebensdauer organischer Bauelemente enthaltend diese Schichten beiträgt. Die erhöhte Leitfähigkeit der Elektronentransportschichten führt zudem zu einer höheren elektronischen Effizienz der Schichten.

Ebenso erfindungsgemäß ist ein organisch elektrisches Bauelement, wobei das Bauelement eine erfindungsgemäße n-leitende organisch elektrische Schicht umfasst. Die erfindungsgemäßen n-Dotanden und das erfindungsgemäße Verfahren zur Herstellung dotierter Elektronentransportschichten lassen sich besonders gut zur Herstellung organisch elektrischer Bauelemente nutzen. Auf diese Art und Weise werden langlebige, effiziente Bauelemente erhalten.

Die erfindungsgemäßen Schichten lassen sich dabei insbesondere in den Standardbauelementen der organischen Elektronik einsetzen, nämlich bevorzugt in den Bauelementen ausgesucht aus der Gruppe umfassend organische Photodioden, Solarzellen, Bipolar- und Feldeffekttransistoren und organische Leuchtdioden. Die erfindungsgemäßen n-Dotanden können für die oben genannten Bauelemente zu einer deutlichen Steigerung der elektronischen Effizienz und der Langlebigkeit beitragen.

Hinsichtlich weiterer Vorteile und Merkmale des vorbeschriebenen Verfahrens wird hiermit explizit auf die Erläuterungen im Zusammenhang mit dem erfindungsgemäßen n-Dotanden, den erfindungsgemäßen Schichten sowie den erfindungsgemäßen Bauelementen verwiesen. Auch sollen erfindungsgemäße Merkmale und Vorteile der erfindungsgemäßen n-Dotanden auch für die erfindungsgemäßen Schichten, das erfindungsgemäße Verfahren und die erfindungsgemäßen organischen Bauelemente anwendbar sein und als offenbart gelten und umgekehrt. Unter die Erfindung fallen auch sämtliche Kombinationen aus zumindest zwei von in der Beschreibung und/oder den Ansprüchen offenbarten Merkmalen.

Die Eigenschaften der erfindungsgemäßen n-Dotierstoffe und mögliche Ausgestaltungen elektrischer Bauelemente, in denen der Dotierstoff zum Einsatz kommen kann, werden nachfolgend anhand von Figuren näher erläutert. Die Figuren zeigen
- Fig. 1: schematisch den Aufbau einer organischen Leuchtdiode (10). Die Leuchtdiode ist aufgebaut aus einer Glas-Schicht (1); Silikon- oder Indium-Zinn-Oxid (ITO)-Schicht (2); Loch-Injektor-Schicht (3); Loch-Transportschicht (HTL) (4); Emitter-Schicht (EML) (5); Loch-Blocker-Schicht (HBL) (6); Elektronen-Transportschicht (ETL) (7); ElektronenInjektorschicht (8)und einer Kathoden-Schicht (9);
- Fig. 2: schematisch den Aufbau einer organischen Solarzelle mit PIN-Struktur (20), welche Licht (21) in elektrischen Strom umwandelt. Die Solarzelle besteht aus einer Schicht aus Indium-Zinn-Oxid (22); einer p-dotierten Schicht(23); einer Absorptions-Schicht (24); einer n-dotierten Schicht (25) und einer Metall-Schicht (26);
- Fig. 3: schematisch einen möglichen Querschnitt eines organischen Feld-Effekt-Transistors (30). Auf einem Substrat (31) ist eine Gate-Elektrode (32), ein Gate-Dielektrikum (33), ein Source und Drain-Kontakt (34 + 35) und ein organischer Halbleiter (36) aufgebracht. Die schraffierten Stellen zeigen die Stellen an denen eine Kontaktdotierung hilfreich ist.

## Patentansprüche

1. Verwendung eines organischen n-Dotierstoffs zur Dotierung organischer Elektronentransportmaterialien, **dadurch gekennzeichnet, dass** der n-Dotierstoff mindestens eine Proazaphosphatran-Verbindung mit einem dreifach N-substituiertem Phosphoratom nach Formel 1 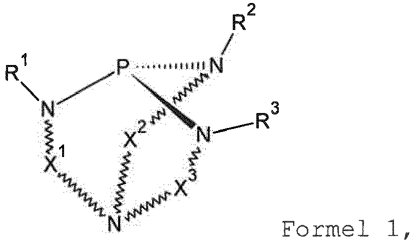 umfasst, wobei
R¹ - R³ unabhängig voneinander ausgesucht sind aus der Gruppe R umfassend H, D, C1-C60 gesättigtes oder ungesättigtes Alkyl, Cycloalkyl, Heteroalkyl, Heterocycloalkyl, C1-C60 Aryl, Alkylaryl, Heteroaryl, Ether, Ester und PR'₃, wobei die Gruppe R' die Substituenten der Gruppe R ohne PR'₃ umfasst, wobei R¹ - R³ unabhängig voneinander verbrückt sein können;
X¹ - X³ unabhängig voneinander ausgesucht sind aus der Gruppe umfassend eine Bindung und substituierte oder nicht-substituierte C1-C10 Alkylen, Cycloalkylen, Arylen und Alkylarylen.

2. Verwendung nach Anspruch 1, wobei die X¹ - X³ unabhängig voneinander ausgesucht sind aus der Gruppe umfassend eine Bindung und substituierte oder nicht-substituierte C1-C6 Alkylen, Cycloalkylen, Arylen und Alkylarylen.

3. Verwendung nach einem der vorhergehenden Ansprüche, wobei die X¹ - X³ unabhängig voneinander ausgesucht sind aus der Gruppe umfassend eine Bindung und substituierte oder nicht-substituierte C1-C5 Alkylen.

4. Verwendung nach einem der vorhergehenden Ansprüche, wobei mindestens eines der X¹ - X³ eine substituierte oder nicht-substituierte C2 Alkylengruppe ist.

5. Verwendung nach einem der vorhergehenden Ansprüche, wobei jedes der X¹ - X³ eine substituierte oder nicht-substituierte C2 Alkylengruppe ist.

6. Verwendung nach einem der vorhergehenden Ansprüche, wobei mindestens zwei der R¹ - R³ über eine Brücke miteinander verbunden sind.

7. Verwendung nach einem der vorhergehenden Ansprüche, wobei der n-Dotierstoff nur eine Proazaphosphatran-Gruppe (PN₄) aufweist.

8. Verwendung nach einem der vorhergehenden Ansprüche, wobei der Dotierstoff mindestens eine Verbindung der folgenden Formeln 2 - 14 umfasst

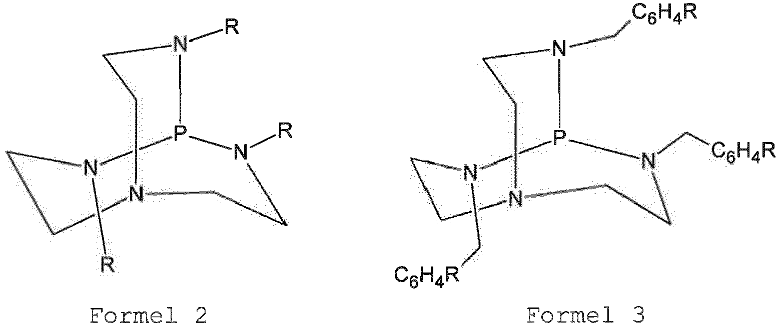

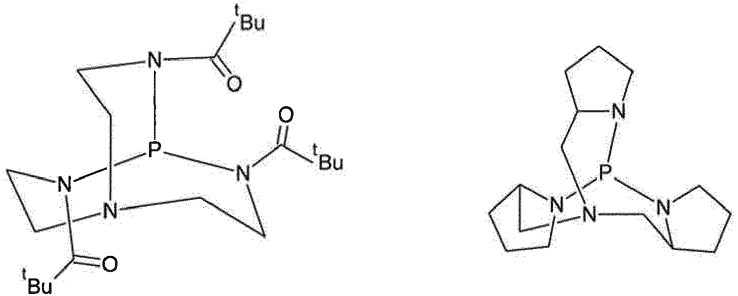

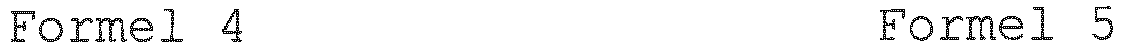

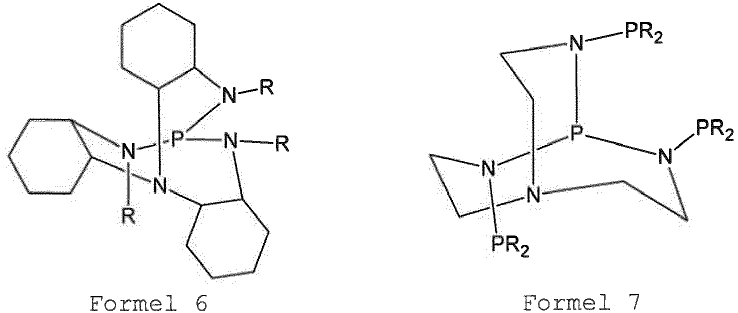

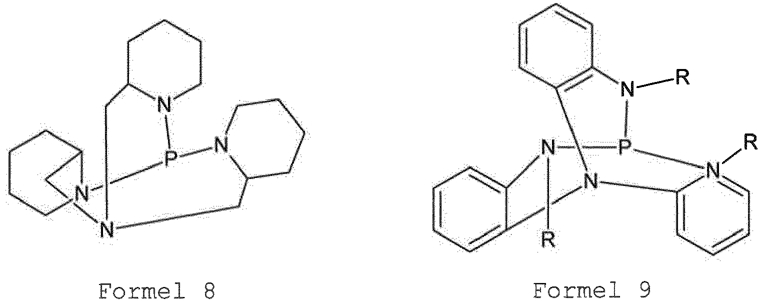

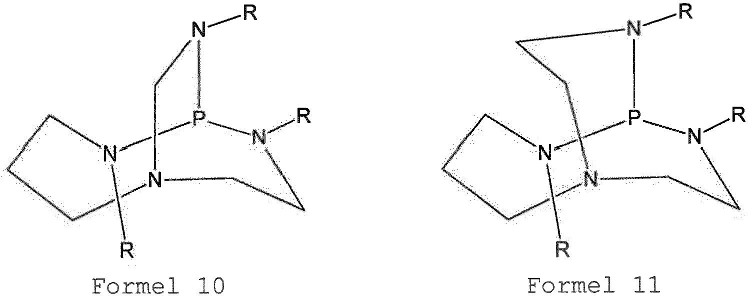

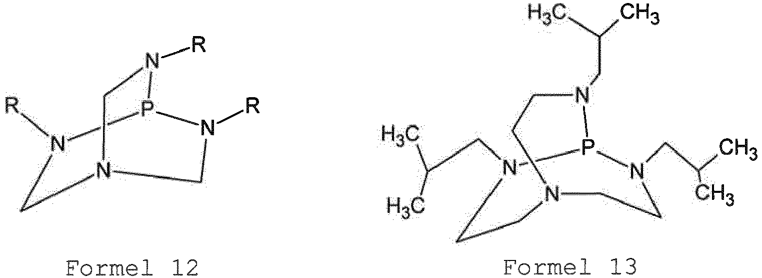

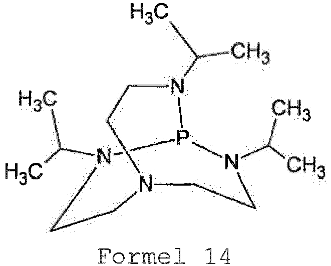

9. Verfahren zur Herstellung n-leitender organisch elektrischer Schichten, **dadurch gekennzeichnet, dass** mindestens eine Proazaphosphatran-Verbindung mit einem dreifach N-substituiertem Phosphoratom nach Formel 1 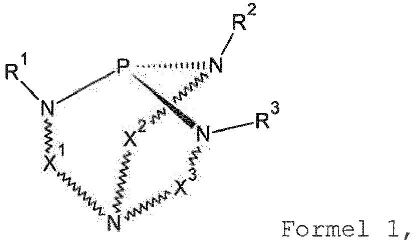 wobei
R¹ - R³ unabhängig voneinander ausgesucht sind aus der Gruppe R umfassend H, D, C1-C60 gesättigtes oder ungesättigtes Alkyl, Cycloalkyl, Heteroalkyl, Heterocycloalkyl, C1-C60 Aryl, Alkylaryl, Heteroaryl, Ether, Ester und PR'₃, wobei die Gruppe R' die Substituenten der Gruppe R ohne PR'₃ umfasst, wobei R¹ - R³ unabhängig voneinander verbrückt sein können;
X¹ - X³ unabhängig voneinander ausgesucht sind aus der Gruppe umfassend eine Bindung und substituierte oder nicht-substituierte C1-C10 Alkylen, Cycloalkylen, Arylen und Alkylarylen zusammen mit einem Matrixmaterial innerhalb einer Schicht abgeschieden und die Verbindung und das Matrixmaterial zur Reaktion gebracht werden.

10. Verfahren nach Anspruch 9, wobei das Matrixmaterial ein elektronenleitendes Matrixmaterial ausgesucht aus der Gruppe umfassend 2,2',2" -(1,3,5-Benzinetriyl)-tris(1-phenyl-1-H-benzimidazole), 2-(4-Biphenylyl)-5-(4-tert-butylphenyl)-1,3,4-oxadiazole; 2,9-Dimethyl-4,7-diphenyl-1,10-phenanthroline (BCP), 8-Hydroxyquinolinolato-lithium; 4-(Naphthalen-1-yl)-3,5-diphenyl-4H-1,2,4-triazole; 1,3-Bis[2-(2,2'-bipyridine-6-yl)-1,3,4-oxadiazo-5-yl]benzene; 4,7-Diphenyl-1,10-phenanthroline (BPhen); 3-(4-Biphenylyl)-4-phenyl-5-tert-butylphenyl-1,2,4-triazole ;Bis(2-methyl-8-quinolinolate)-4-(phenylphenolato)aluminium; 6,6'-Bis[5-(biphenyl-4-yl)-1,3,4-oxadiazo-2-yl]-2,2'-bipyridyl ;2-phenyl-9,10-di(naphthalen-2-yl)-anthracene; 2,7-Bis[2-(2,2'-bipyridine-6-yl)-1,3,4-oxadiazo-5-yl]-9,9-dimethylfluorene; 1,3-Bis[2-(4-tert-butylphenyl)-1,3,4-oxadiazo-5-yl]benzene; 2-(naphthalen-2-yl)-4,7-diphenyl-1,10-phenanthroline; 2,9-Bis(naphthalen-2-yl)-4,7-diphenyl-1,10-phenanthroline; Tris(2,4,6-trimethyl-3-(pyridin-3-yl)phenyl)borane; 1-methyl-2-(4-(naphthalen-2-yl)phenyl)-1H-imidazo[4,5-f][1,10]phenanthroline; Phenyl-dipyrenylphosphine oxide; 3,3',5,5'-tetra[(m-pyridyl)-phen-3-yl]biphenyl; 1,3,5-tris[(3-pyridyl)-phen-3-yl]benzol; 4,4'-bis(4,6-diphenyl-1,3,5-triazin-2-yl)biphenyl; 1,3-bis[3,5-di(pyridin-3-yl)phenyl]benzol; Diphenylbis(4-(pyridin-3-yl)phenyl)silan; 3,5-di(pyren-1-yl)pyridin; 1,3,5-tri(p-pyrid-3-yl-phenyl)benzol; 2,4,6-tris(3'-(pyridin-3-yl)biphenyl-3-yl)-1,3,5-triazin; Naphthalintetracarbonsäuredianhydrid bzw. dessen Imide; Perylentetracarbonsäuredianhydrid bzw. dessen Imide; Materialien basierend auf Silolen mit einer Silacyclopentadieneinheit ist.

11. n-leitende organisch elektrische Schicht, hergestellt nach einem Verfahren nach einem der Ansprüche 9 oder 10.

12. Organisch elektrisches Bauelement, **dadurch gekennzeichnet, dass** das Bauelement eine dotierte n-leitende organisch elektrische Schicht nach Anspruch 11 umfasst.

13. Organisch elektrisches Bauelement nach Anspruch 12, wobei das Bauelement ausgesucht ist aus der Gruppe umfassend organische Photodioden, Solarzellen, Bipolar- und Feldeffekttransistoren und organische Leuchtdioden.

## Claims

1. Use of an organic n-dopant for doping organic electron transport materials, **characterized in that** the n-dopant comprises at least one proazaphosphatrane compound having a triply N-substituted phosphorus atom of formula 1 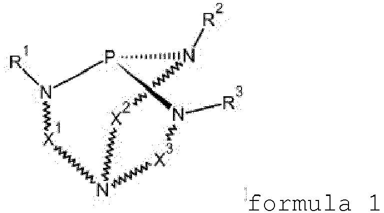 where
R¹ - R³ independently of one another are selected from the group R encompassing H, D, C1-C60 saturated or unsaturated alkyl, cycloalkyl, heteroalkyl, heterocycloalkyl, C1-C60 aryl, alkylaryl, heteroaryl, ethers, esters, and PR'₃, where the group R' encompasses the substituents of group R without PR'₃, where R¹ - R³ independently of one another may be bridged;
X¹ - X³ independently of one another are selected from the group encompassing a bond and substituted or unsubstituted C1-C10 alkylene, cycloalkylene, arylene, and alkylarylene.

2. Use according to Claim 1, wherein the X¹ - X³ independently of one another are selected from the group encompassing a bond and substituted or unsubstituted C1-C6 alkylene, cycloalkylene, arylene, and alkylarylene.

3. Use according to either of the preceding claims, wherein the X¹ - X³ independently of one another are selected from the group encompassing a bond and substituted or unsubstituted C1-C5 alkylene.

4. Use according to any of the preceding claims, wherein at least one of the X¹ - X³ is a substituted or unsubstituted C2 alkylene group.

5. Use according to any of the preceding claims, wherein each of the X¹ - X³ is a substituted or unsubstituted C2 alkylene group.

6. Use according to any of the preceding claims, wherein at least two of the R¹ - R³ are joined to one another via a bridge.

7. Use according to any of the preceding claims, wherein the n-dopant has only one proazaphosphatrane group (PN₄).

8. Use according to any of the preceding claims, wherein the dopant comprises at least one compound of the formulae 2-14 below

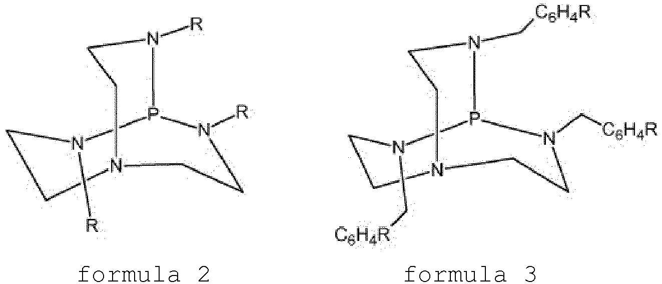

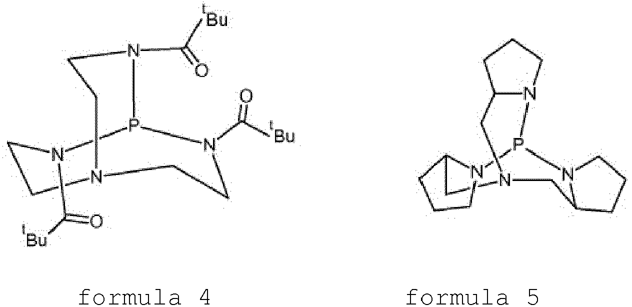

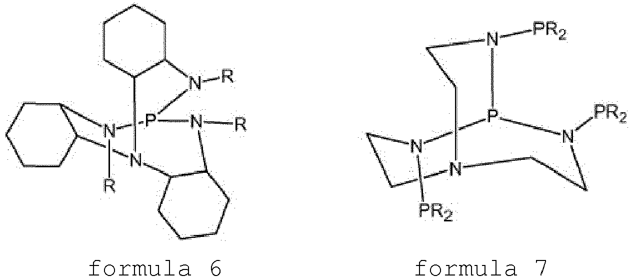

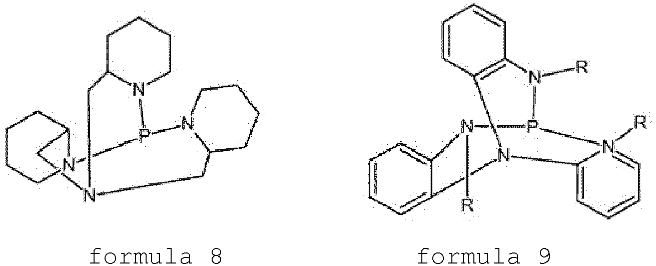

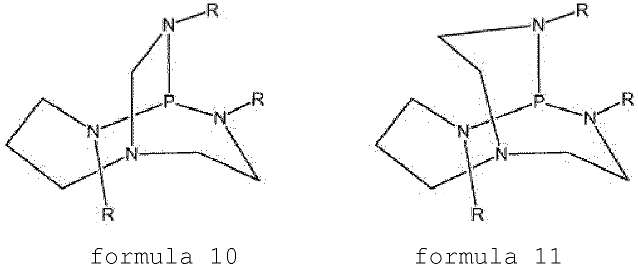

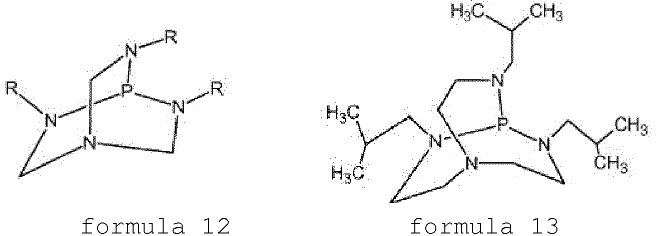

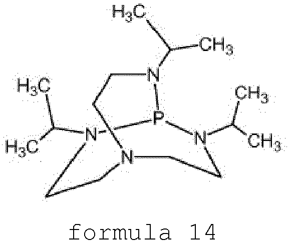

9. Method for producing n-conducting organic-electrical layers, **characterized in that** at least one proazaphosphatrane compound having a triply N-substituted phosphorus atom of formula 1 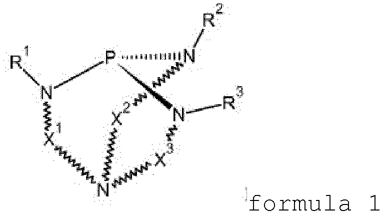 where
R¹ - R³ independently of one another are selected from the group R encompassing H, D, C1-C60 saturated or unsaturated alkyl, cycloalkyl, heteroalkyl, heterocycloalkyl, C1-C60 aryl, alkylaryl, heteroaryl, ethers, esters, and PR'₃, where the group R' encompasses the substituents of group R without PR'₃, where R¹ - R³ independently of one another may be bridged;
X¹ - X³ independently of one another are selected from the group encompassing a bond and substituted or unsubstituted C1-C10 alkylene, cycloalkylene, arylene, and alkylarylene is deposited together with a matrix material within a layer, and the compound and the matrix material are reacted.

10. Method according to Claim 9, wherein the matrix material is an electron-conducting matrix material selected from the group encompassing 2,2',2"-(1,3,5-benzinetriyl)tris(1-phenyl-1-H-benzimidazole), 2-(4-biphenylyl)-5-(4-tert-butylphenyl)-1,3,4-oxadiazole; 2,9-dimethyl-4,7-diphenyl-1,10-phenanthroline (BCP), 8-hydroxyquinolinolatolithium; 4-(naphthalen-1-yl)-3,5-diphenyl-4H-1,2,4-triazole; 1,3-bis[2-(2,2'-bipyridine-6-yl)-1,3,4-oxadiazo-5-yl]benzene; 4,7-diphenyl-1,10-phenanthroline (BPhen); 3-(4-biphenylyl)-4-phenyl-5-tert-butylphenyl-1,2,4-triazole; bis(2-methyl-8-quinolinolate)-4-(phenylphenolato)aluminum; 6,6'-bis[5-(biphenyl-4-yl)-1,3,4-oxadiazo-2-yl]-2,2'-bipyridyl; 2-phenyl-9,10-di(naphthalen-2-yl)anthracene; 2,7-bis[2-(2,2'-bipyridine-6-yl)-1,3,4-oxadiazo-5-yl]-9,9-dimethylfluorene; 1,3-bis[2-(4-tert-butylphenyl)-1,3,4-oxadiazo-5-yl]benzene; 2-(naphthalen-2-yl)-4,7-diphenyl-1,10-phenanthroline; 2,9-bis(naphthalen-2-yl)-4,7-diphenyl-1,10-phenanthroline; tris(2,4,6-trimethyl-3-(pyridin-3-yl)phenyl)borane; 1-methyl-2-(4-(naphthalen-2-yl)phenyl)-1H-imidazo[4,5-f][1,10]phenanthroline; phenyldipyrenylphosphine oxide; 3,3',5,5'-tetra[(m-pyridyl)phen-3-yl]biphenyl; 1,3,5-tris[(3-pyridyl)phen-3-yl]benzene; 4,4'-bis(4,6-diphenyl-1,3,5-triazin-2-yl)biphenyl; 1,3-bis[3,5-di(pyridin-3-yl)phenyl]benzene; diphenylbis(4-(pyridin-3-yl)phenyl)silane; 3,5-di(pyren-1-yl)pyridine; 1,3,5-tri(p-pyrid-3-ylphenyl)benzene; 2,4,6-tris(3'-(pyridin-3-yl)biphenyl-3-yl)-1,3,5-triazine; naphthalenetetracarboxylic dianhydride and its imides; perylenetetracarboxylic dianhydride and its imides; materials based on siloles, having a silacyclopentadiene unit.

11. N-conducting organic-electrical layer produced by a method according to either of Claims 9 and 10.

12. Organic-electrical component, **characterized in that** the component comprises a doped, n-conducting organic-electrical layer according to Claim 11.

13. Organic-electrical component according to Claim 12, wherein the component is selected from the group encompassing organic photodiodes, solar cells, bipolar and field-effect transistors, and organic light-emitting diodes.

## Revendications

1. Utilisation d'une substance organique dopante de type n pour le dopage de matières organiques de transport d'électrons, **caractérisée en ce que** la substance dopante de type n comprend au moins un composé de proazaphosphatran comprenant un atome de phosphore trois fois substitué avec un atome d'azote, répondant à la formule 1 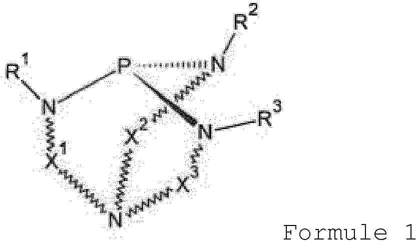 dans laquelle
R¹ à R³ sont choisis, indépendamment l'un de l'autre, parmi le groupe R comprenant H, D, un groupe en C₁-C₆₀ saturé ou insaturé d'alkyle, cycloalkyle, hétéroalkyle, hétérocycloalkyle, un groupe en C₁-C₆₀ d'aryle, alkylaryle, hétéroaryle, éther, ester et PR'₃, le groupe R' comprenant les substituants du groupe R sans le groupe PR'₃, dans laquelle R¹ à R³ peuvent être pontés indépendamment l'un de l'autre ;
X¹ à X³ sont choisis, indépendamment l'un de l'autre, parmi le groupe comprenant une liaison et un groupe en C₁-C₁₀ substitué ou non substitué d'alkylène, cycloalkylène, arylène et alkylarylène.

2. Utilisation selon la revendication 1, dans laquelle X¹ à X³ sont choisis, indépendamment l'un de l'autre, parmi le groupe comprenant une liaison et un groupe en C₁-C₆ substitué ou non substitué d'alkylène, cycloalkylène, arylène et alkylarylène.

3. Utilisation selon l'une quelconque des revendications précédentes, dans laquelle X¹ à X³ sont choisis, indépendamment l'un de l'autre, parmi le groupe comprenant une liaison et un groupe alkylène en C₁-C₅, substitué ou non substitué.

4. Utilisation selon l'une quelconque des revendications précédentes, dans laquelle au moins un des radicaux X¹ à X³ représente un groupe alkylène en C₂, substitué ou non substitué.

5. Utilisation selon l'une quelconque des revendications précédentes, dans laquelle chacun des radicaux X¹ à X³ représente un groupe alkylène en C₂, substitué ou non substitué.

6. Utilisation selon l'une quelconque des revendications précédentes, dans laquelle au moins deux des radicaux R¹ à R³ sont reliés l'un à l'autre par l'intermédiaire d'un pont.

7. Utilisation selon l'une quelconque des revendications précédentes, dans laquelle la substance dopante de type n ne représente qu'un seul groupe proazaphosphatran (PN₄).

8. Utilisation selon l'une quelconque des revendications précédentes, dans laquelle la substance dopante comprend au moins un composé répondant aux formules suivantes 2 à 14 :

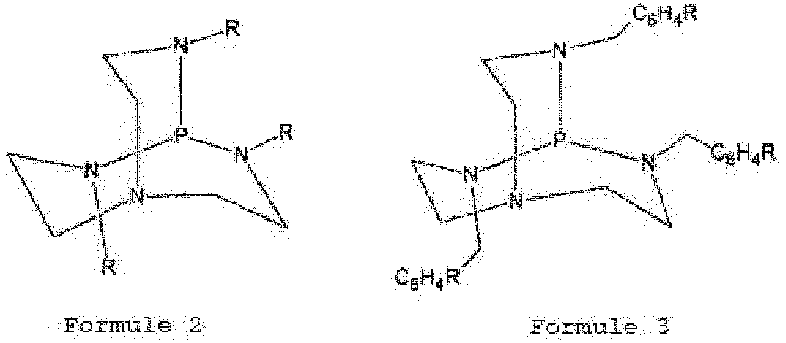

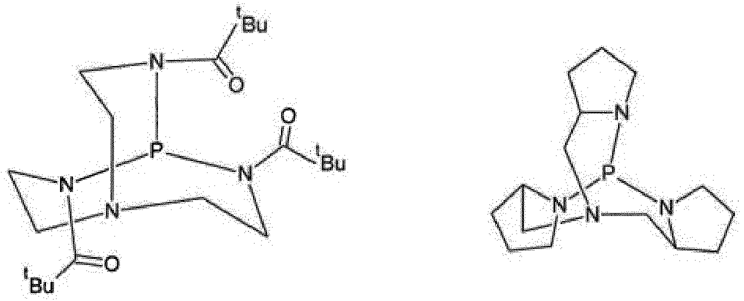

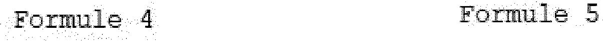

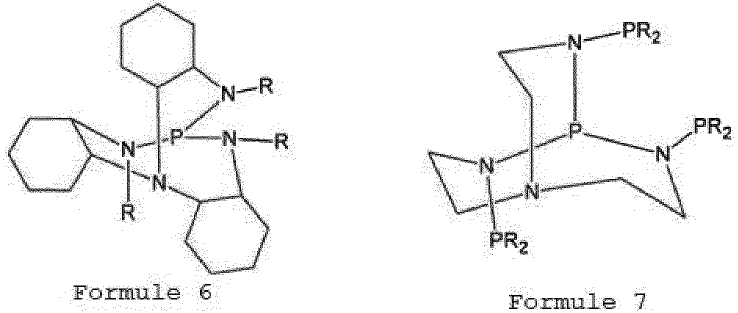

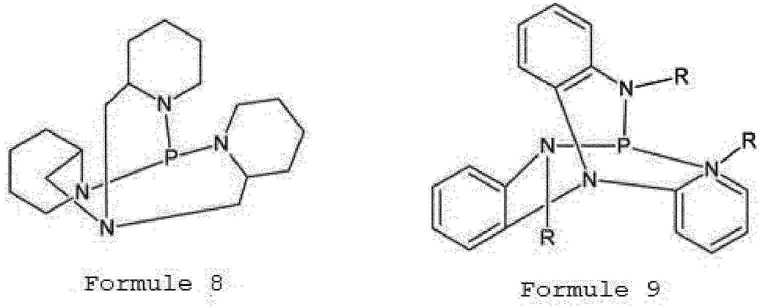

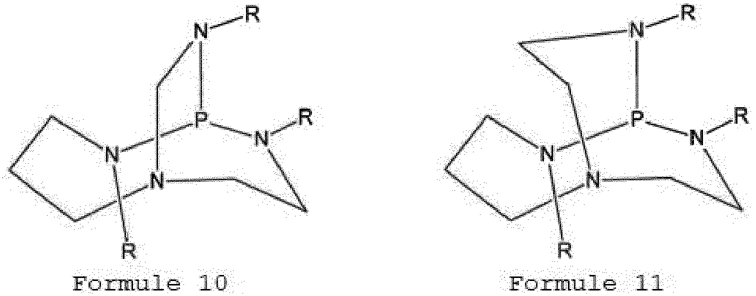

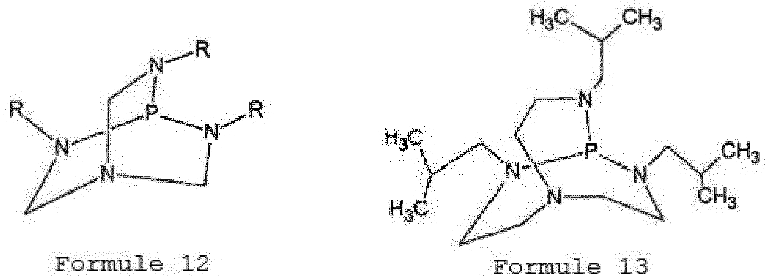

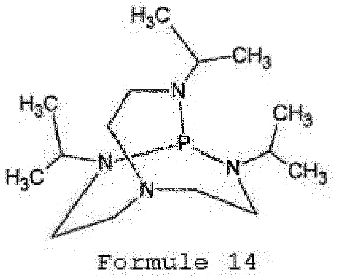

9. Procédé pour la fabrication de couches organo-électriques conductrices de type n, **caractérisé en ce qu'**on précipite au moins un composé de proazaphosphatran comprenant un atome de phosphore trois fois substitué avec un atome d'azote, répondant à la formule 1 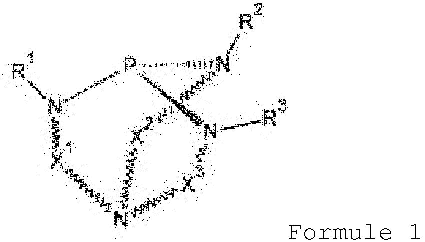 dans laquelle
R¹ à R³ sont choisis, indépendamment l'un de l'autre, parmi le groupe R comprenant H, D, un groupe en C₁-C₆₀ saturé ou insaturé d'alkyle, cycloalkyle, hétéroalkyle, hétérocycloalkyle, un groupe en C₁-C₆₀ d'aryle, alkylaryle, hétéroaryle, éther, ester et PR'₃, le groupe R' comprenant les substituants du groupe R sans le groupe PR'₃, dans laquelle R¹ à R³ peuvent être pontés indépendamment l'un de l'autre ;
X¹ à X³ sont choisis, indépendamment l'un de l'autre, parmi le groupe comprenant une liaison et un groupe en C₁-C₁₀ substitué ou non substitué d'alkylène, cycloalkylène, arylène et alkylarylène, de manière conjointe avec une matière matricielle à l'intérieur d'une couche et on amène le composé et la matière matricielle à réagir.

10. Procédé selon la revendication 9, dans lequel la matière matricielle représente une matière matricielle conductrice d'électrons choisie parmi le groupe comprenant le 2,2',2"-(1,3,5-benzinetriyl)-tris(1-phényl-1H-benzimidazole) ; le 2-(4-biphénylyl)-5-(4-tert-butylphényl)-1,3,4-oxadiazole ; la 2,9-diméthyl-4,7-diphényl-1,10-phénanthroline (BCP) ; le 8-hydroxyquinolinolato-lithium ; le 4-(naphthalén-1-yl)-3,5-diphényl-4H-1,2,4-triazole ; le 1,3-bis[2-(2,2'-bipyridine-6-yl)-1,3,4-oxadiazo-5-yl]benzène ; la 4,7-diphényl-1,10-phénanthroline (BPhen) ; le 3-(4-biphénylyl)-4-phényl-5-tert-butylphényl-1,2,4-triazole ; le bis(2-méthyl-8-quinolinolate)-4-(phénylphénolato)aluminium ; le 6,6'-bis[5-biphényl-4-yl)-1,3,4-oxadiazo-2-yl]-2,2'-bipyridyle ; le 2-phényl-9,10-di(naphthalén-2-yl)-anthracène ; le 2,7-bis[2-(2,2'-bipyridine-6-yl)-1,3,4-oxadiazo-5-yl]-9,9-diméthylfluorène ; le 1,3-bis[2-(4-tert-butylphényl)-1,3,4-oxadiazo-5-yl]benzène ; la 2-(naphthalén-2-yl)-4,7-diphényl-1,10-phénanthroline ; la 2,9-bis(naphthalén-2-yl)-4,7-diphényl-1,10-phénanthroline ; le tris(2,4,6-triméthyl-3-(pyridin-3-yl)phényl)borane ; la 1-méthyl-2-(4-(naphthalén-2-yl)phényl)-1H-imidazo[4,5-f][1,10]phénanthroline ; l'oxyde de phényl-dipyrénylphosphine ; le 3,3',5,5'-tétra[(m-pyridyl)-phén-3-yl]biphényle ; le 1,3,5-tris[(3-pyridyl)-phén-3-yl]benzène ; le 4,4'-bis(4,6-diphényl-1,3,5-triazin-2-yl)biphényle ; le 1,3-bis[3,5-di(pyridin-3-yl)phényl]benzène ; le diphényl-bis(4-(pyridin-3-yl)phényl)silane ; la 3,5-di(pyrén-1-yl)pyridine ; le 1,3,5-tri(p-pyrid-3-yl-phényl)benzène ; la 2,4,6-tris(3'-(pyridin-3-yl)biphényl-3-yl)-1,3,5-triazine ; le dianhydride de l'acide naphtalènetétracarboxylique, respectivement ses imides ; le dianhydride de l'acide pérylènetétracarboxylique, respectivement ses imides ; des matières à base de silols comprenant une unité de silacyclopentadiène.

11. Couche organo-électrique conductrice de type n, fabriquée conformément à un procédé selon l'une quelconque des revendications 9 ou 10.

12. Composant organo-électrique, **caractérisé en ce que** le composant comprend une couche organo-électrique conductrice de type n selon la revendication 11.

13. Composant organo-électrique selon la revendication 12, dans lequel le composant est choisi parmi le groupe comprenant des photodiodes organiques, des cellules photovoltaïques, des transistors bipolaires et à effet de champ et des diodes électroluminescentes organiques.
